Europäisches Patentamt

European Patent Office

Office européen des brevets

(19)

(11) Numéro de publication: **0 1 1 5 7 1 1**
**B1**

(12) # FASCICULE DE BREVET EUROPEEN

(45) Date de publication du fascicule du brevet:
**08.10.86**

(51) Int. Cl.⁴: **C 30 B 15/00,** C 30 B 15/34,
C 30 B 29/06, C 30 B 29/60,
B 22 D 25/04, H 01 L 21/00

(21) Numéro de dépôt: **83400279.2**

(22) Date de dépôt: **09.02.83**

(54) **Procédé de préparation de plaques d'un matériau métallique ou semi-métallique par moulage sans contact direct avec les parois du moule.**

(43) Date de publication de la demande:
**15.08.84 Bulletin 84/33**

(45) Mention de la délivrance du brevet:
**08.10.86 Bulletin 86/41**

(84) Etats contractants désignés:
**BE DE FR GB IT NL**

(56) Documents cités:
**DE - A - 2 520 764**
**DE - A - 2 916 389**
**DE - B - 2 508 651**
**US - A - 4 121 965**
**US - A - 4 157 373**

(73) Titulaire: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Potard, Claude, 9 Bld Jomardière, F-38120 St Egreve (FR)**
Inventeur: **Dusserre, Pierre, 24 rue Chapotier, F-38120 St Egreve (FR)**

(74) Mandataire: **Mongrédien, André et al, c/o BREVATOME 25, rue de Ponthieu, F-75008 Paris (FR)**

ACTORUM AG

# Description

La présente invention a pour objet un procédé de préparation de plaques d'un matériau métallique ou semi-métallique à partir d'une masse liquide par moulage sans contact direct avec les parois d'un récipient.

La préparation de cristaux semi-conducteurs en plaques, par exemple, présente des inconvénients dus au contact établi entre le liquide et son moule. En outre, en croissance cristalline, les interactions possibles entre le matériau constitutif du moule et le liquide peuvent provoquer des phénomènes de germination parasite lors de la solidification, ainsi que des contraintes mécaniques au refroidissement.

Pour remédier à ces inconvénients, on a utilisé des procédés dans la masse liquide du matériau à élaborer est séparée des parois du creuset ou de moule par un film liquide d'un deuxième matériau chimiquement inerte vis-à-vis du premier, non miscible avec lui et ayant un bon pouvoir mouillant vis-à-vis des parois du creuset ou du moule. Des méthodes de tirage vertical utilisent déjà le principe d'encapsulation (enrobage par un matériau non miscible).

La présente invention a pour objet un procédé de ce genre permettant le réalisation de plaques planes d'un matériau métallique ou semi-métallique.

Selon la principale caractéristique du procédé objet de l'invention, le matériau métallique ou semi-métallique à élaborer (appelé «premier matériau» dans la suite du présent texte) se présentent sous la forme d'une masse liquide contenue dans un dispositif d'élaboration comprenant d'une parte un creuset contenant en outre un deuxième matériau, chimiquement inerte vis-à-vis du premier, et d'autre part un moyen de mise en forme, et le dit deuxième matériau est de densité au plus égale à celle du premier matériau, est non miscible avec lui, présente un point de fusion très inférieur à celui du premier matériau et possède un pouvoir mouillant supérieur à celui dudit premier matériau vis-à-vis du dispositif d'élaboration; d'autre part le procédé comporte les étapes suivantes:

— on fait descendre dans le creuset un moule comportant un ensemble de plaques réfractaires parallèles et équidistantes les unes des autres jusqu'à ce que l'extrémité inférieure de celles-ci vienne au contact du deuxième matériaux qui mouille les parois du moule,
— on fait pénétrer le premier matériau dans les espaces situés entre les plaques, celui-ci étant séparé des plaques par un film liquide du deuxième matériau,
— on refroidit de manière dirigée jusqu'à solidification du matériau à élaborer, le deuxième matériau restant sous forme liquide,
— on retire les plaques,
— on évacue le deuxième matériau en excès,
— on laisse refroidir jusqu'à température ambiante, et
— on élimine la pellicule du deuxième matériau qui pourrait encore adhérer au premier matériau.

Un tel procédé trouve une application particulièrement intéressante pour la préparation de plaques de silicium servant soit de substrat pour la préparation, par épitaxie en phase vapeur, de plaques de silicium photovoltaïque, soit directement de cellules photovoltaïques.

Dans le domaine de la fabrication des cellules photovoltaïques, le silicium est le matériau qui présente actuellement le meilleur rapport prix/efficacité de convention. La méthode de production de silicium la plus utilisée actuellement consiste à découper en plaques de grands lingots obtenus par solidification contrôlée. Ce découpage en plaques est un problème tecnologique difficile qui implique des investissements importants, de grandes consommations d'énergie et de matière, et enfin des traitements de surfaces longs et coûteux. L'une des applications les plus intéressantes du procédé objet de l'invention est justement la préparation de plaques de silicium à moindre coût et avec un bon état de surface.

Avantageusement, le deuxième matériau servant à créer un film liquide protecteur au contact des parois du moule est un fluorure alcalino-terreux ou un mélange de fluorures alcalino-terreux, par exemple un mélange de fluorures de calcium et de magnésium dans le cas de réalisation de plaques de silicium.

L'invention apparaîtra mieux à la lecture de la description qui va suivre, donnée à titre d'exemple purement illustratif et nullement limitatif, en référence aux dessins annexés sur lesquels:

la figure 1 est une vue schématique en coupe verticale d'un dispositif permettant la mise en oeuvre du procédé objet de l'invention, et

la figure 2 est une vue schématique en coupe verticale d'un autre dispositif permettant la mise en oeuvre du procédé objet de l'invention.

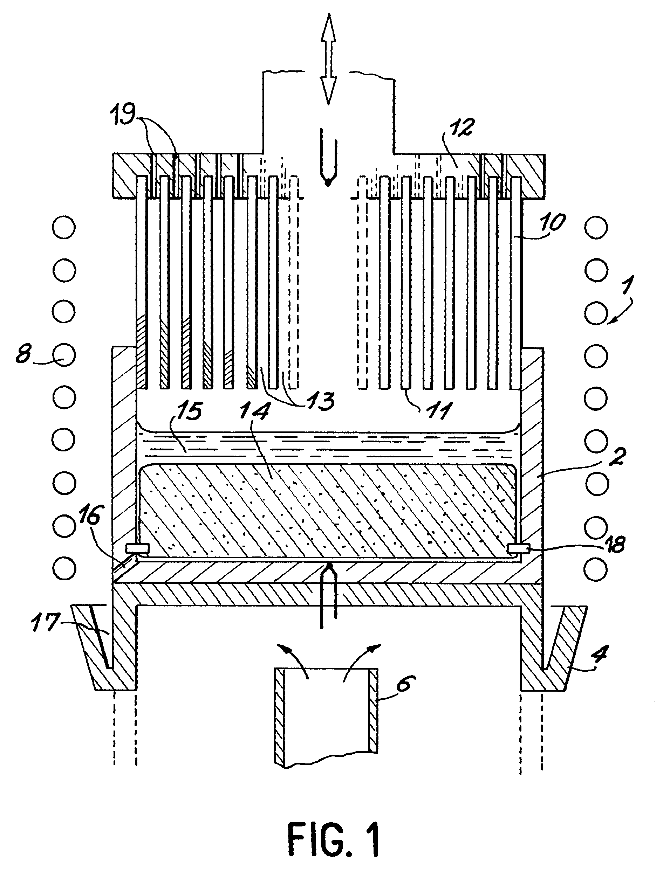

La figure 1 représente l'ensemble d'un dispositif, portant la référence générale 1, qui permet de préparer simultanément un grand nombre de plaques de silicium. Un creuset 2 en graphite est disposé sur un socle 4 en graphite assurant un bon contact thermique et le plus uniforme possible avec la surface de base du creuset. Ce socle peut être refroidi par circulation interne d'un fluide calo-porteur arrivant par une canalisation 6. Le creuset 2, de forme rectangulaire, est chauffé sur ses quatre faces par des résistances électriques 8. Dans le cas particulier décrit ici, il s'agit de produire des plaques de silicium rectangulaires de 80 × 80 mm de côté et de 1 à 1,5 mm d'épaisseur. Pour cela, on a donné au creuset une forme de parallélépipède de 100 mm de profondeur, 100 mm de large et environ 300 mm de long. Le moyen de mise en forme ou moule est constitué par une série de 45 plaques telles que 10 maintenues par un support 12 mobile verticalement de façon à pouvoir être introduites à l'intérieur du creuset 2. Afin d'autoriser la montée des matériaux entre les plaques, les parties supérieures des espaces entre les plaques communiquent avec l'atmosphère par des orifices 19. Les plaques 10 sont en graphite et ont une épaisseur de 4,5 mm. Elles sont maintenues rigoureusement équidistantes les unes des autres par un montage approprié. Pour assurer une pénétration régulière des materiaux entre les plaques, le moule et le creuset doivent s'emboîter avec précision. Sur la figure, on voit encore une masse de silicium liquide 14 dans le fond du creuset surmontée d'une masse liquide 15 d'un deuxième matériau, la masse 14 étant également séparée des parois du creuset 2 par un film liquide du matériau 15. Dans l'exemple décrit ici, le deuxième matériau 15 est un mélange eutectique de fluorure de calcium et de fluorure de magnésium dont le point de fusion est 980°C. Une opération de préparation de plaques de silicium avec se dispositif se déroule de la manière suivante:

Après fusion des deux matériaux 14 et 15, on fait descendre l'ensemble des plaques 10 jusqu'à ce que l'extrémité inférieure 11 de celles-ci vienne au contact de la surface libre du liquide 15. On descend lentement les plaques 10 pour que le liquide 15, qui a un bon pouvoir mouillant imprègne totalement ces plaques. On continue le mouvement de descente jusqu'à ce que l'extrémité inférieure 11 des plaques 10 atteigne la masse de silicium liquide 14. A ce moment-là, le silicium commence à monter dans les espaces 13 entre les plaques au fur et à mesure qu'elles sont descendues, mais il reste séparé de celles-ci par un film liquide du matériau 15 qui se maintient sur les parois du moule. Lorsque les plaques 10 ont atteint le bas de leur course, on effectue la solidification du silicium à partir du bas par admission d'un fluide de refroidissement sous le socle 4. On obtient ainsi des plaques de silicium solide séparées des plaques en graphite ou en alumine 10 par un film du deuxième matériau 15 qui est encore liquide puisque le point de fusion de celui-ci est choisi nettement inférieur au point de fusion du silicium. Ce dernier étant solidifié et le deuxième matériau 15 étant encore liquide, on retire les plaques 10. Dans le cas de la figure 1, des ergots 18 sont prévus pour maintenir le silicium solidifié dans le creuset. Le deuxième matériau liquide est évacué des intervalles entre les plaques de silicium. On peut pour cela prévoir des ouvertures 16 à la partie inférieure du creuset 2 afin que ce liquide puisse s'écouler dans un réceptacle 17 ménagé dans le support en graphite 4. Le creuset 2 contenant les plaques de silicium est alors refroidi jusqu'à la température ambiante et la pellicule résiduelle du matériau 15 qui pourrait encore adhérer aux plaques est dissoute par lavage acide. Les plaques de silicium sont alors extraites et un deuxième cycle peut commencer. Le dispositif qui à été réalisé a permis d'atteindre un rendement de 1 m² par heure. Bien evidemment on pourrait séparer les plaques après solidification et effectuer alors un lavage sur les plaques séparées.

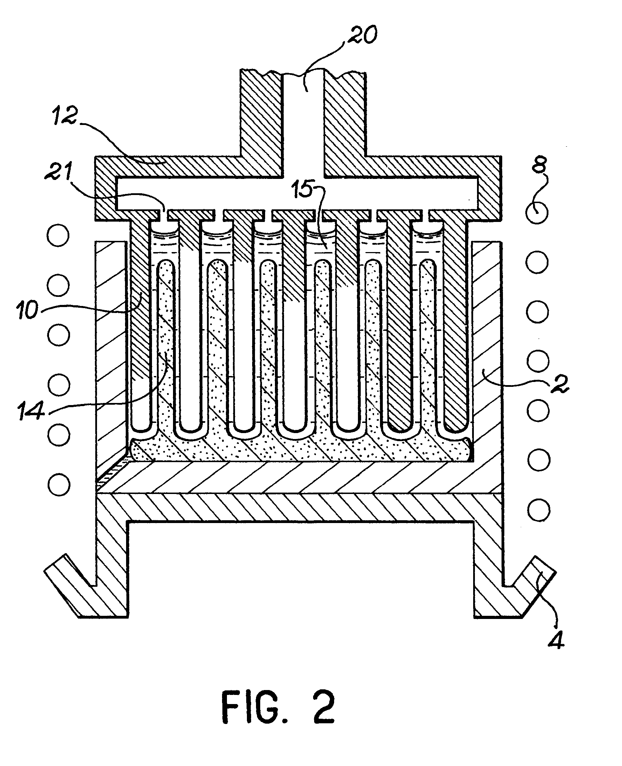

La figure 2 représente, en coupe, une vue schématique d'un autre appareil permettant la mise en oeuvre du procédé; les éléments correspondant à des éléments semblables de la figure 1 portent des numéros de référence identiques. On reconnaît sur cette figure un creuset 2 en graphite déposé sur un socle 4 qui assure un bon contact thermique avec la base du creuset 2, les résistances chauffantes 8 assurant le chauffage du creuset.

Sur cette figure les plaques 10, solidaires du support mobile 12 sont montrées descendues dans le creuset et après solidification des plaques de silicium 14. L'extraction des plaques de silicium, séparées des plaques 10 du moule par le bain du deuxième matériau 15 encore liquide, s'effectue en introduisant un fluide sous pression (azote par exemple) dans un conduit 20 usiné dans le support 12. Des ouvertures 21 permettent au fluide sous pression de pénétrer entre les plaques 10 du moule. Ainsi, lors du mouvement ascendant du moule, les plaques de silicium sont maintenus dans le creuset 2. Ici seuls changent les moyens d'extraction du silicium en plaques, les diverses étapes du procédé décrit à la figure 1 demeurant identiques.

Le procédé selon l'invention présente des avantages particulièrement intéressants puisqu'on a pu obtenir de très bonnes structures cristallines et des états de surface bruts de haute qualité. D'autre part, le flux liquide interposé le long des parois du moule joue un rôle de lubrifiant facilitant les opérations d'extraction du moule. L'opération de démoulage à chaud avant solidification du film liquide intercalaire permet un gain de temps et élimine les risques de détérioration des plaques de silicium à cause des contraintes mécaniques qui apparaissent au refroidissement complet de la charge. En effet, après démoulage et évacuation de l'excès du deuxième matériau, seule la solidification de la pellicule résiduelle très mince du deuxième matériau peut apporter des tensions mécaniques, qui restent par conséquent très faibles. Ces tensions sont encore diminuées grâce à l'adhérence limitée du deuxième matériau, ce qui garantit un bon état de surface des plaques de silicium. Quant à l'élimination complète de la pellicule résiduelle, elle est obtenue par dissolution sélective acide, par l'emploi d'un fondant ou par un procédé physique.

Il est bien entendu que l'invention ne se limite pas aux exemples qui viennent d'être décrits, mais qu'on peut imaginer des variantes sans sortir pour autant du cadre de l'invention: c'est ainsi que l'homme de l'art pourra choisir le matériau constituant le film liquide protecteur et le matériau constituant les parois du moule en fonction de ce que l'on veut obtenir.

**Revendications**

1. Procédé de préparation de plaques d'un premier matériau métallique ou semi-métallique à partir d'une masse liquide (14) de ce matériau contenue dans un dispositif d'élaboration comprenant d'une part un creuset 2 contenant en outre un deuxième matériau (15), chimiquement inerte vis-à-vis du premier matériau (14) et d'autre part un moyen de mise en forme (10, 12), caractérisé d'une parte en ce que ledit deuxième matériau (15) est de densité au plus égale à celle dudit premier matériau (14), est non miscible avec lui, présente un point de fusion très inférieur à celui dudit premier matériau et possède un pouvoir mouillant supérieur à celui dudit premier matériaux vis-à-vis du dispositif d'élaboration et d'autre part en ce qu'il comporte les étapes suivantes:
— on fait descendre dans le creuset (2) un moule comportant un ensemble de plaques réfractaires (10) parallèles et équidistantes les unes des autres jusqu'à ce que l'extrémité inférieure (11) de celles-ci vienne au contact du deuxième matériau (15) qui mouille les parois du moule,
— on fait pénétrer le premier matériau (14) dans les espaces (13) situés entre les plaques (10), tout en étant séparé de celles-ci par un film liquide du deuxième matériau,
— on réfroidit de manière dirigée jusqu'à solidification du matériau à élaborer (14), le deuxième matériau (15) restant sous forme liquide,
— on retire les plaques (10),
— on évacue le deuxième matériau (15) en excès,
— on laisse réfroidir jusqu'à température ambiante, et
— on élimine la pellicule du deuxième matériau qui pourrait encore adhérer au premier matériau.

2. Procédé selon la revendication 1, caractérisé en ce que le matériau à elaborer est du silicium.

3. Procédé selon la revendication 1, caractérisé en ce que le deuxième matériau est un produit à base de fluorures alcalino-terreux.

4. Procédé selon la revendication 1, caracterisé en ce que le dispositif d'élaboration est en graphite de haute pureté.


**Patentansprüche**

1. Verfahren zur Herstellung von Platten aus einem ersten metallischen oder halbleitenden Material ausgehend von einer flüssigen Masse (14) dieses Materials, die in einer Herstellungsvorrichtung enthalten ist, die einerseits einen Schmelztiegel (2), der ferner ein zweites in bezug auf das erste Material (14) chemisch inertes Material (15) enthält, und andererseits eine Formungseinrichtung (10, 12) aufweist, gekennzeichnet einerseits dadurch, dass das zweite Material (15) eine Dichte aufweist, die höchstens gleich derjenigen des ersten Materials (14) ist, einen Schmelzpunkt besitzt, der weit unter demjenigen des ersten Materials liegt, und ein grösseres Benetzungsvermögen als dasjenige des ersten Materials in bezug auf die Herstellungsvorrichtung aufweist, und dass andererseits das Verfahren die folgenden Schritte umfasst:

— man senkt in den Schmelztiegel (2) eine Form, die eine Gesamtheit von hitzebeständigen, parallelen und von einander gleich beabstandeten Platten (10) umfasst, ab, bis deren untere Enden (11) in Berührung mit dem zweiten Material (15) kommen, welches die Wände der Form benetzt,
— man lässt das erste Material (14) in die sich zwischen den Platten (10) befindenden Räume (13) eindringen, wobei dieses von diesem durch einen Flüssigkeitsfilm des zweiten Materials getrennt ist,
— man kühlt gesteuert bis zu dem Erstarrungspunkt des herzustellenden Materials (14) ab, wobei das zweite Material (15) im flüssigen Zustand bleibt,
— man zieht die Platten (10) heraus,
— man entfernt das überschüssige zweite Material (15),

— man lässt auf Umgebungstemperatur abkühlen, und
— man entfernt den Film des zweiten Materials der noch auf dem ersten Material anhaften könnte.

2. Verfahren nach Anspruch 1, dadurch gekennzeichnet, dass das herzustellende Material Silizium ist.

3. Verfahren nach Anspruch 1, dadurch gekennzeichnet, dass das zweite Material ein Produkt auf der Basis von Erdalkalifluoriden ist.

4. Verfahren nach Anspruch 1, dadurch gekennzeichnet, dass die Herstellungsvorrichtung aus Graphit hoher Reinheit besteht.


**Claims**

1. Process for the preparation of plates of a first metallic or semi-metallic material from a liquid mass (14) of this material, which mass is contained in a processing device comprising on the one hand a vessel 2 which also contains a second material (15), which is chemically inert in relation to the first material (14) and on the other hand a shaping means (10, 12), characterized on the one hand in that the said second material (15) has a density at most equal to that of the said first material (14) and is not miscible therewith, has a melting point which is very far below that of the said first material and possesses a wetting power which is grater than that of the said first material in relation to the processing device, and on the other hand in that the said process comprises the following steps:

— a mould including an assembly of refractory plates (10) which are parallel and equidistant from one another is caused to descend into the vessel (2), until the lower extremity (11) of the said refractory plates comes into contact with the second material (15), which wets the walls of the mould,
— the first material (14) is caused to penetrate into the spaces (13) situated between the plates (10), while remaining separated from the latter by a liquid film of the second material,
— cooling takes place in a controlled manner so as to effect solidification of the material to be processed (14), the second material (15) remaining in liquid form,
— the plates (10) are withdrawn,
— the second material (15) in excess is removed,
— cooling is allowed to take place so as to reach ambient temperature, and
— the film of the second material which may still adhere to the first material is removed.

2. Process according to Claim 1, characterized in that the material to be processed is silicon.

3. Process according to Claim 1, characterized in that the second material is a product based on alkaline earth metal fluorides.

4. Process according to Claim 1, characterized in that the processing device is constructed of graphite of high purity.

**FIG. 1**

FIG. 2